# EUROPEAN PATENT APPLICATION

(11) **EP 4 557 927 A1**
(43) Date of publication of application: **21.05.2025**
(21) Application number: 23855097.4
(22) Date of filing: 09.08.2023
(51) Int. Cl.: H10K 77/10, H10K 50/84, H04M 1/02, G06F 1/16, G09F 9/30, H10K 102/00

(54) **DISPLAY STRUCTURE INCLUDING METAL LAYER AND ELECTRONIC DEVICE INCLUDING SAME**

(30) Priority: 17.08.2022 KR 20220102538; 30.09.2022 KR 20220125335
(71) Applicant: Samsung Electronics Co., Ltd., Suwon-si, Gyeonggi-do 16677 (KR)
(72) Inventor: SHIN, Hyunho, Suwon-si, Gyeonggi-do 16677 (KR)
(74) Representative: Walaski, Jan Filip
(86) International application number: PCT/KR2023/011754
(87) International publication number: WO 2024/039130

(57) **Abstract**

An electronic device according to an embodiment of the present disclosure may comprise housings and a display unit, the display unit comprising a display panel, a protective layer, a metal layer, and a plurality of adhesive layers, and at least a portion of the display unit being bendable at a bending section, wherein the metal layer comprises a first metal layer, which includes a first bending region and a second bending region that are disposed at the bending section of the display unit, and a second metal layer disposed at one end and the other end of the first metal layer, and the one end and the other end of the first metal layer at which the second metal layer is disposed may be positioned at a distance from the second bending region.

## Description

### [Technical Field]

Embodiments of the disclosure relate to a display structure including a metal layer and an electronic device including the same.

### [Background Art]

A display laminate structure of a foldable electronic device may include a display panel, a protective layer, a metal layer, a waterproof layer, and adhesive layers for bonding individual layers. The metal layer included in the display laminate structure may include a metal layer for display reinforcement and a metal layer for improving heat dissipation performance.

The metal layer for reinforcing the display may include a grid pattern located in a bending portion of the foldable electronic device. The metal layer for display reinforcement may include a material advantageous for forming the grid pattern (e.g., stainless steel). The metal layer for improving heat dissipation performance may include a material advantageous for heat dissipation (e.g., copper).

### [Disclosure of Invention]

### [Technical Problem]

A metal layer for display reinforcement and a metal layer for improving heat dissipation performance may be disposed in separate layers, respectively. Since each metal layer is disposed in a separate layer, the thickness of the display laminate structure may be thickened, and the process of manufacturing the display laminate structure may become complicated. Therefore, a metal layer arrangement structure capable of reducing the thickness of the display laminate structure is required.

### [Solution to Problem]

An electronic device according to an embodiment of the disclosure may include a housing, and a display unit disposed on one surface of the housing.

The display unit according to an embodiment of the disclosure may include a display panel, a protective layer configured to protect the display panel, a metal layer configured to support the display panel, and multiple adhesive layers. The display unit may be configured to be at least partially bendable in a bending section. The metal layer may include a first metal layer including a first bending area disposed at the bending section of the display unit and second bending areas positioned at opposite ends of the first bending area, the first metal layer being configured to reinforce strength of the display unit, and a second metal layer disposed at opposite ends of the first metal layer. The opposite ends of the first metal layer where the second metal layer is disposed may be spaced apart from the second bending areas.

The metal layer according to an embodiment of the disclosure may include a first metal layer that includes a bending area disposed in a bending section of the display unit and reinforces the strength of the display unit, and a second metal layer that is disposed at each of opposite ends of the first metal layer. The opposite ends of the first metal layer at which the second metal layer is disposed may be spaced apart from the bending area.

### [Advantageous Effects of invention]

An electronic device according to an embodiment of the disclosure may reduce the thickness of a display laminate structure by having at least a portion of a metal layer for display reinforcement and a metal layer for improving heat dissipation performance disposed in the same layer.

### [Brief Description of Drawings]

FIG. 1 is a block diagram of an electronic device according to an embodiment in a network environment.
FIGS. 2A, 2B, and 2C are views illustrating an electronic device according to an embodiment of the disclosure in unfolded and folded states.
FIG. 3 is an exploded perspective view of a first display according to an embodiment of the disclosure.
FIGS. 4A and 4B are views illustrating an electronic device including a bending section according to an embodiment of the disclosure.
FIGS. 5A and 5B are views illustrating an electronic device including a first bending section and second bending sections according to an embodiment of the disclosure.
FIGS. 6A and 6B are views illustrating a display unit according to an embodiment of the disclosure.
FIGS. 7A and 7B are views illustrating a display unit including multiple bonding surfaces according to an embodiment of the disclosure.
FIGS. 8A and 8B are views illustrating a display unit including two bonding surfaces according to an embodiment of the disclosure.
FIGS. 9A and 9B are views illustrating a display unit including two bonding surfaces according to an embodiment of the disclosure.
FIGS. 10A and 10B are views illustrating a display unit including a support part according to an embodiment of the disclosure.
FIGS. 11A and 11B are views illustrating a display unit including support plates according to an embodiment of the disclosure.

### [Mode for the Invention]

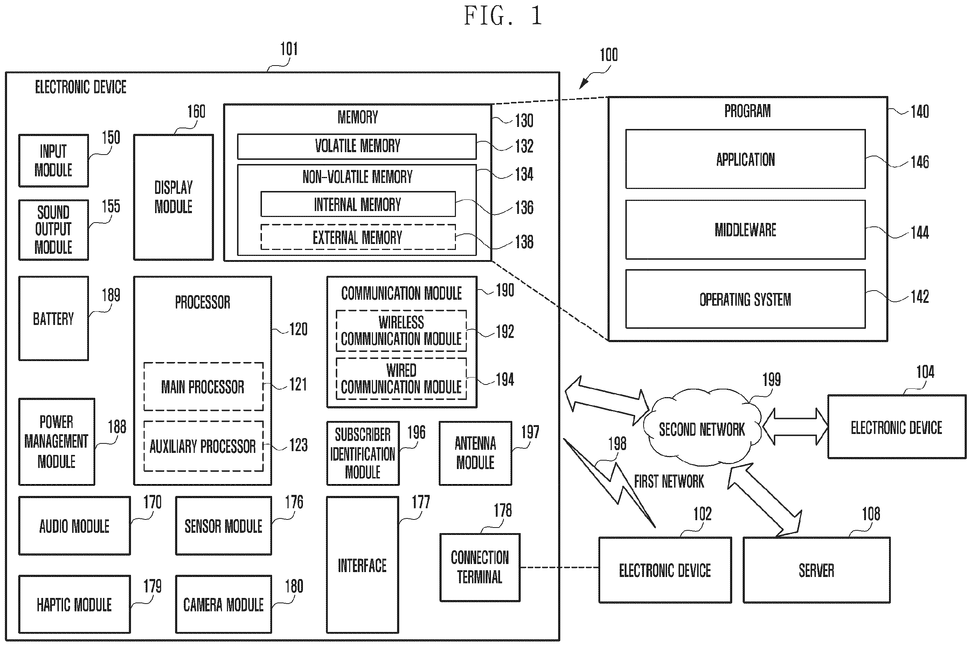

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

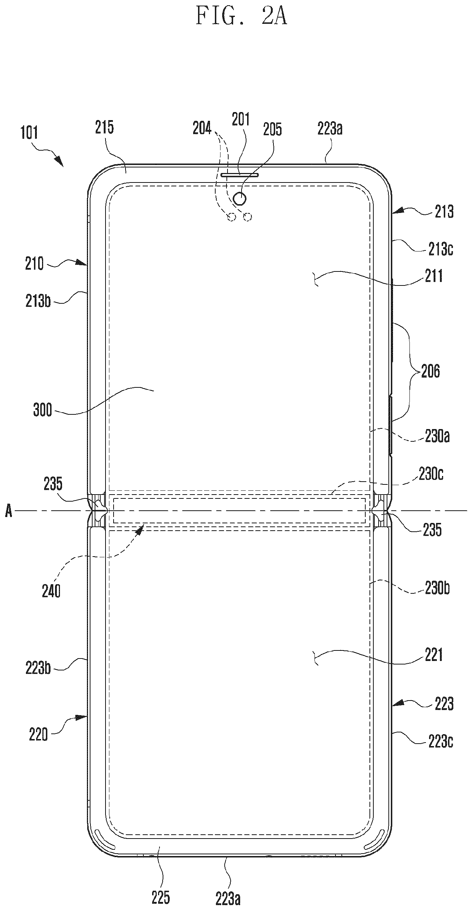

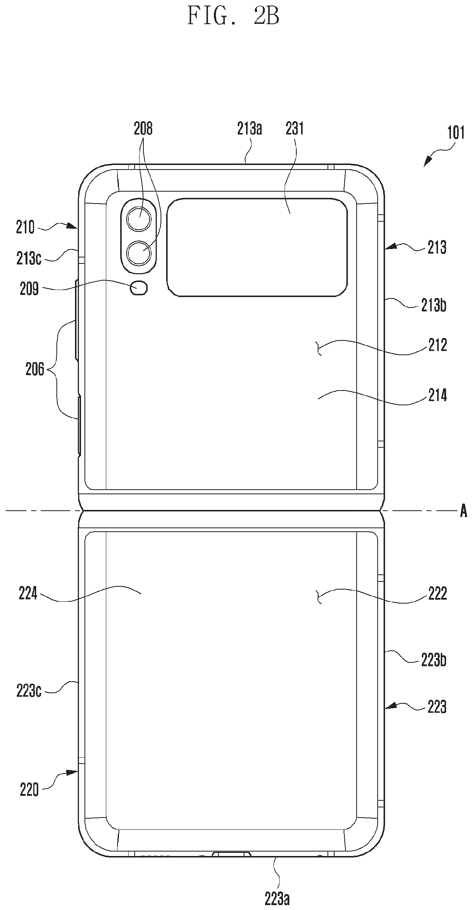

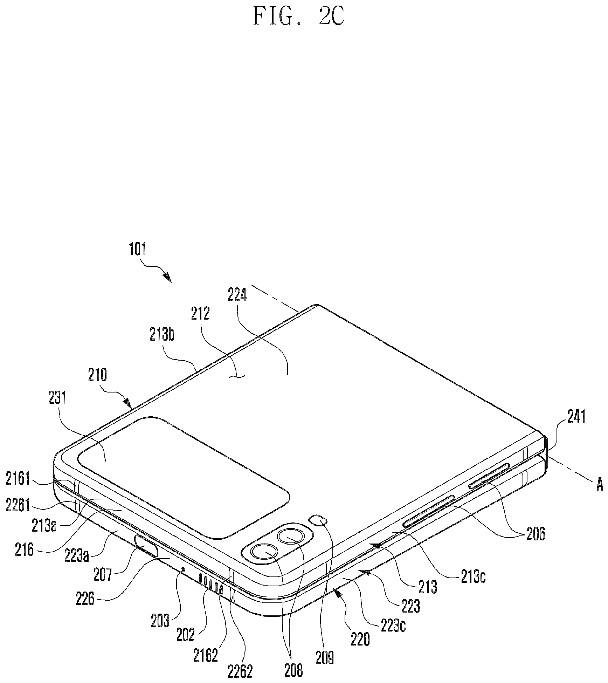

FIGS. 2A, 2B, and 2C are views illustrating an electronic device 101 according to an embodiment of the disclosure in unfolded and folded states.

FIG. 2A is a plan view illustrating the front surface of the electronic device according to an embodiment of the disclosure in the unfolded state.

FIG. 2B is a plan view illustrating the rear surface of the electronic device according to an embodiment of the disclosure in the unfolded state.

FIG. 2C is a perspective view illustrating the electronic device according to an embodiment of the disclosure in the folded state.

Referring to FIGS. 2A to 2C, the electronic device 101 may include a pair of housings 210 and 220 (e.g., foldable housings), which are rotatably coupled to each other to be folded about a hinge module (e.g., the hinge module 240 in FIG. 2A) and to face each other. In some embodiments, two or more hinge modules (e.g., the hinge module 240 in FIG. 2A) may be disposed such that the electronic device is folded in the same direction or in different directions.

According to an embodiment, the electronic device 101 may include a first display 300 (e.g., a foldable display) disposed in an area defined by the pair of housings 210 and 220.

According to an embodiment, the first housing 210 and the second housing 220 are disposed on opposite sides of a folding axis (the axis A), and may have substantially symmetrical shapes with respect to the folding axis (the axis A). The first housing 210 and the second housing 220 may form an angle or a distance therebetween, which may be variable depending on whether the electronic device 101 is in the unfolded or flat state (e.g., a second state), in the folded state (e.g., a first state), or in the intermediate state.

According to an embodiment, the pair of housings 210 and 220 may include the first housing 210 (e.g., a first housing structure) coupled to the hinge module (e.g., the hinge module 240 in FIG. 2A) and the second housing 220 (e.g., e.g., a second housing structure) coupled to the hinge module (e.g., the hinge module 240 in FIG. 2A). The first housing 210 may include, in the unfolded state, a first surface 211 oriented in a first direction (e.g., the forward direction) and a second surface 212 oriented in a second direction (e.g., the rearward direction), opposite to the first surface 211. The second housing 220 may include a third surface 221 oriented in the first direction and a fourth surface 222 oriented in the second direction, in the folded state.

According to an embodiment, the electronic device 101 may be operated such that, in the unfolded state, the first surface 211 of the first housing 210 and the third surface 221 of the second housing 220 are oriented in substantially the same first direction and in the folded state, the first surface 211 and the third surface 221 face each other.

According to an embodiment, the electronic device 101 may be operated such that, in the unfolded state, the second surface 212 of the first housing 210 and the fourth surface 222 of the second housing 220 are oriented in substantially the same second direction and in the folded state, the second surface 212 and the fourth surface 222 are oriented in opposite directions. For example, in the folded state, the second surface 212 may be oriented in the first direction, and the fourth surface 222 may be oriented in the second direction.

According to an embodiment, the first housing 210 may include a first side surface frame 213 at least partially forming the exterior of the electronic device 101, and a first rear surface cover 214 coupled to the first side surface frame 213 and forming at least a portion of the second surface 212 of the electronic device 101. The first side surface frame 213 may include a first side surface 213a, a second side surface 213b extending from one end of the first side surface 213a, and a third side face 213c extending from the other end of the first side surface 213a. The first side surface frame 213 may be configured in a rectangular (e.g., square or oblong) shape with the first side surface 213a, the second side surface 213b, and the third side surface 213c.

According to an embodiment, the second housing 220 may include a second side surface frame 223 at least partially forming the exterior of the electronic device 101, and a second rear surface cover 224 coupled to the second side surface frame 223 and forming at least a portion of the fourth surface 222 of the electronic device 101. According to an embodiment, the second side surface frame 223 may include a fourth side surface 223a, a fifth side surface 223b extending from one end of the fourth side surface 223a, and a sixth side surface 223c extending from the other end of the fourth side surface 223a. The second side surface frame 223 may be formed in a rectangular shape with the fourth side surface 223a, the fifth side surface 223b, and the sixth side surface 223c.

According to an embodiment, the pair of housings 210 and 220 are not limited to the illustrated shape and assembly, but may be implemented by other shapes or other combinations and/or assemblies of components. For example, in some embodiments, the first side surface frame 213 and the first rear surface cover 214 may be integrally configured, and the second side surface frame 223 and the second rear surface cover 224 may be integrally configured.

According to an embodiment, when the electronic device 101 is in the unfolded state, the second side surface 213b of the first side surface frame 213 and the fifth side surface 223b of the second side surface frame 223 may be connected to each other without a gap. When the electronic device 101 is in the unfolded state, the third side surface 213c of the first side surface frame 213 and the sixth side surface 223c of the second side surface frame 223 may be connected to each other without a gap. The electronic device 101 may be configured such that, in the unfolded state, the total length of the second side surface 213b and the fifth side surface 223b is longer than the length of first side surface 213a and/or the length of the fourth side surface 223a. In addition, the electronic device 220 may be configured such that the total length of the third side surface 213c and the sixth side surface 223c is longer than the length of the first side surface 213a and/or the length of the fourth side surface 223a.

According to an embodiment, the first side surface frame 213 and/or the second side surface frame 223 may be made of metal or may further include polymer injection-molded onto the metal. According to an embodiment, the first side surface frame 213 and/or the second side surface frame 223 may include at least one conductive section 216 and/or 226 electrically isolated by one or more polymer-based split portions 2161 and 2162 and/or 2261 and 2262. In this case, the at least one conductive section may be used as antennas operating in at least one predetermined band (e.g., a legacy band) by being electrically connected to a wireless communication circuit included in the electronic device 101.

According to an embodiment, the first rear surface cover 214 and/or the second rear surface cover 224 may be made of at least one of, for example, coated or colored glass, ceramic, polymer, or metal (e.g., aluminum, stainless steel (STS), or magnesium) or a combination of at least two of these materials.

According to an embodiment, the first display 300 may be disposed to extend from the first surface 211 of the first housing 210 to at least a portion of the third surface 221 of the second housing 220 across the hinge module (e.g., the hinge module 240 in FIG. 2A). For example, the first display 300 may substantially include a first area 230a corresponding to the first surface 211, a second area 230b corresponding to the second surface 221, and a third area 230c interconnecting the first area 230a and the second area 230b and corresponding to the hinge module (e.g., the hinge module 240 in FIG. 2A). According to an embodiment, the first display 300 may include a flexible display, at least a portion of which is transformable into a flat shape or a curved shape. The area division of the first display 300 is only an exemplary physical division by the pair of housings 210 and 220 and the hinge device (e.g., the hinge module 240 in FIG. 2A), and the first display 300 may display a seamless single entire screen substantially with the pair of housings 210 and 220 and the hinge device (e.g., the hinge module 240 in FIG. 2A). According to an embodiment, the first area 230a and the second area 230b may have overall symmetrical shapes or partially asymmetrical shapes with respect to the third area 230c. According to an embodiment, the electronic device 101 may include a first protective cover 215 (e.g., a first protective frame or a first decoration member) coupled along the periphery of the first housing 210. The electronic device 101 may include a second protective cover 225 (e.g., a second protective frame or a second decoration member) coupled along the periphery of the second housing 220. According to an embodiment, the first protective cover 215 and/or the second protective cover 225 may be made of a metal or polymer material. The first protective cover 215 and/or the second protective cover 225 may be used as a decoration member.

According to an embodiment, the first display 300 may be located such that the periphery of the first area 230a is interposed between the first housing 210 and the first protective cover 215. The first display 300 may be located such that the periphery of the second area 230b is interposed between the second housing 220 and the second protective cover 225.

According to an embodiment, the first display 300 may be located to allow the periphery of the first display 300 corresponding to the protective cap to be protected by a protective cap 235 disposed in an area corresponding to the hinge module (e.g., the hinge module 240 in FIG. 2A). Accordingly, the periphery of the first display 300 may be substantially protected from the outside. According to an embodiment, the electronic device 101 may include a hinge housing 241 (e.g., a hinge cover) configured to support the hinge module (e.g., the hinge module 240 in FIG. 2A). When the electronic device 101 is in the folded state, the hinge housing 241 is disposed to be exposed outside, and when the electronic device 300 is in the unfolded state, the hinge housing 241 is disposed to be invisible from the outside by being introduced into a first space (e.g., the inner space of the first housing 210) and a second space (e.g., the inner space of the second housing 220). In some embodiments, the first display 300 may be disposed to extend from at least a portion of the second surface 212 to at least a portion of the fourth surface 222. In this case, the electronic device 101 may be folded to expose the first display 300 outside (an out-folding type).

According to an embodiment, the electronic device 101 may include a second display 231 disposed separately from the first display 300. The second display 231 may be disposed on the second surface 212 of the first housing 210 to be at least partially exposed, thereby displaying status information of the electronic device 101 in the folded state, in place of the display function of the first display 300. According to an embodiment, the second display 231 may be disposed to be visible from the outside through at least a portion of the first rear surface cover 214. In some embodiments, the second display 231 may be disposed on the fourth surface 222 of the second housing 220. In this case, the second display 231 may be disposed to be visible from the outside through at least a portion of the second rear surface cover 224. According to an embodiment, the second display 231 may include a touch panel including a touch sensor configured to detect a touch. According to an embodiment, the second display 231 may include any one of an organic light-emitting diode (OLED) display, a light-emitting diode (LED) display, and a liquid crystal display (LCD). According to an embodiment, the second display 231 may include a flexible display.

According to an embodiment, the electronic device 101 may include at least one of an input device 203 (e.g., a microphone), sound output devices 201 and 202, a sensor module 204, camera devices 205 and 208, key input devices 206, or a connector port 207. In the illustrated embodiment, the input device 203 (e.g., a microphone), the sound output devices 201 and 202, the sensor module 204, the camera devices 205 and 208, the key input devices 206, or the connector port 207 are indicated as holes or shapes provided in the first housing 210 or the second housing 220, but may be defined as including practical electronic components (e.g., an input device, a sound output device, a sensor module, or a camera device) disposed inside the electronic device 101 and operating through the holes or shapes.

According to an embodiment, the input device 203 may include at least one microphone 203 disposed in the second housing 220. In some embodiments, the input device 203 may include multiple microphones 203 arranged to detect the direction of sound. In some embodiments, the multiple microphones 203 may be disposed at appropriate positions in the first housing 210 and/or the second housing 220. The sound output devices 201 and 202 may include speakers 201 and 202. The speakers 201 and 202 may include a phone call receiver 201 disposed in the first housing 210 and a speaker 202 disposed in the second housing 220. In some embodiments, the input device 203, the sound output devices 201 and 202, and the connector port 207 may be disposed in a space provided in the first housing 210 and/or a space provided in the second housing 220 of the electronic device 101, and may be exposed to the external environment through one or more holes provided in the first housing 210 and/or the second housing 220. At least one connector port 207 may be used to transmit/receive power and/or data to/from an external electronic device. In some embodiments, at least one connector port (e.g., an ear jack hole) may accommodate a connector (e.g., an ear jack) for transmitting/receiving an audio signal to/from an external electronic device. In some embodiments, the holes provided in the first housing 210 and/or the second housing 220 may be commonly used for the input device 203 and the sound output devices 201 and 202. In some embodiments, the sound output devices 201 and 202 may include a speaker that operates without holes provided in the first housing 210 and/or the second housing 220 (e.g., a piezo speaker).

According to an embodiment, the sensor modules 204 may generate electrical signals or data values corresponding to an internal operating state or an external environmental state of the electronic device 101. The sensor module 204 may detect an external environment through, for example, the first surface 211 of the first housing 210. In some embodiments, the electronic device 101 may further include at least one sensor module disposed to detect an external environment through the second surface 212 of the first housing 210. At least one sensor module disposed on the second surface 212 of the first housing 210 may be disposed to detect an external environment through at least some of the camera devices 205 and 208 and/or the second display 231. The at least one sensor module disposed on the second surface 212 may include an illuminance sensor. The sensor modules 204 (e.g., an illuminance sensor) may be disposed under the first display 300 to detect an external environment through the first display 300. The sensor modules 204 may include at least one of an angle sensor, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, an illuminance sensor, a proximity sensor, a biometric sensor, an ultrasonic sensor, or an illuminance sensor 204.

According to an embodiment, the camera devices 205 and 208 may include a first camera device 205 disposed on the first surface 211 of the first housing 210 (e.g., a front camera device) and a second camera device 208 disposed on the second surface 212 of the first housing 210. The electronic device 101 may further include a flash 209 disposed near the second camera device 208.

According to an embodiment, the camera devices 205 and 208 may include one or more lenses, an image sensor, and/or an image signal processor. The flash 209 may include, for example, a light-emitting diode or a xenon lamp. According to an embodiment, the camera devices 205 and 208 may be arranged such that two or more lenses (e.g., a wide-angle lens, an ultra-wide-angle lens, or a telephoto lens) and image sensors are located on one surface (e.g., the first surface 211, the second surface 212, the third surface 221, or the fourth surface 222) of the electronic device 101. In some embodiments, the camera devices 205 and 208 may each include time-of-flight (TOF) lenses and/or an image sensor.

According to an embodiment, the key input device 206 (e.g., a key button) may be disposed on the third side surface 213c of the first side surface frame 213 of the first housing 210. In some embodiments, the key input devices 206 may be disposed on at least one of the other side surfaces 213a and 213b of the first housing 210 and/or the side surfaces 223a, 223b, and 223c of the second housing 220. In some embodiments, the electronic device 101 may not include some or all of the key input devices 206, and the key input devices 206 not included in the electronic device 100 may be implemented in another form such as soft keys on the first display 300. In some embodiments, the key input devices 206 may be implemented by using pressure sensors included in the first display 300.

According to an embodiment, some of the camera devices 205 and 208 (e.g., the first camera device 205) or the sensor modules 204 may be arranged to be exposed through the first display 300. For example, the first camera device 205 or the sensor modules 204 may be disposed in the inner space of the electronic device 101 to be in contact with the external environment through an opening (e.g., a through hole) at least partially provided in the first display 300. In an embodiment, some sensor modules 204 may be disposed to execute their functions in the inner space of the electronic device 101 without being visually exposed through the first display 300. For example, in this case, the opening in the area facing the sensor modules of the first display 300 may be unnecessary.

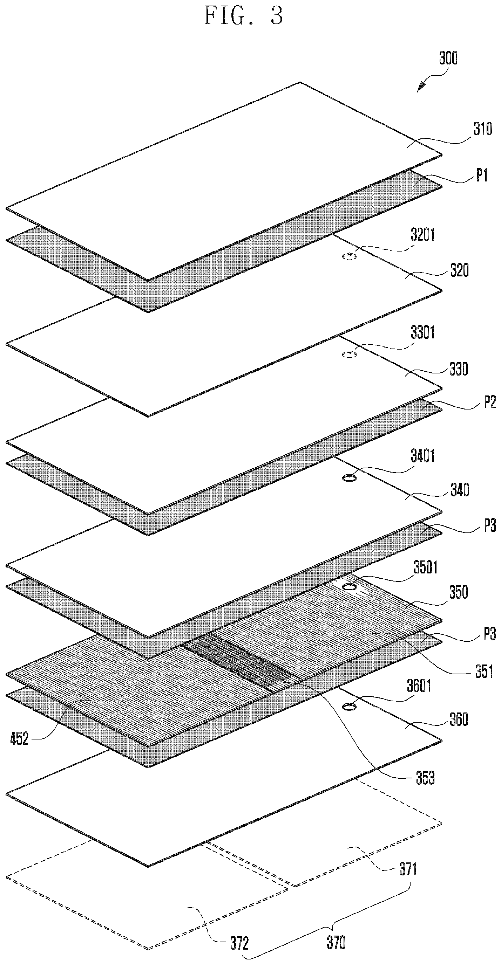

FIG. 3 is an exploded perspective view of the first display 300 according to an embodiment of the disclosure.

A display (e.g., the first display 300) according to exemplary embodiments of the disclosure may include an unbreakable (UB)-type OLED display (e.g., a curved display). However, the disclosure is not limited thereto, and the first display 300 may include an on-cell-touch active-matrix organic light-emitting diode (AMOLED) (OCTA)-type flat display.

Referring to FIG. 3, the first display 300 may include a window layer 310, a polarizer (POL) (320) (e.g., a polarizing film) sequentially arranged on the rear surface of the window layer 310, a display panel 330, a polymer layer 340, a metal sheet layer 350, and a digitizer 360. In some embodiments, the display may further include a metal reinforcement plate 370 disposed under the metal sheet layer 350. According to an embodiment, the window layer 310 may include a glass layer. According to an embodiment, the window layer 310 may include ultra-thin glass (UTG). In some embodiments, the window layer 310 may include polymer. In this case, the window layer 310 may include polyethylene terephthalate (PET) or polyimide (PI). In some embodiments, multiple window layers 310 may be disposed. In some embodiments, the window layer 310 may be disposed with an adhesive having a weaker adhesive strength or a thinner thickness than the adhesives of other layers so that the window layer 310 can be well separated from the other layers. In some embodiments, the window 310 may further include various coating layers provided on at least a portion of at least one of the top surface, the bottom surface, and/or the side surface thereof.

According to an embodiment, the window layer 310, the polarizer 320, the display panel 330, the polymer layer 340, the metal sheet layer 350, and the digitizer 360 may be disposed to cross at least a portion of the first surface (e.g., the first surface 111 in FIG. 2A) of the first housing (e.g., the first housing 110 in FIG. 2A) and the third surface (e.g., the third surface 121 in FIG. 2A) of the second housing (e.g., the second housing 120 in FIG. 2A). The window layer 310, the polarizer 320, the display panel 330, the polymer layer 340, the metal sheet layer 350, and the digitizer 360 may be attached to each other via adhesives P1, P2, P3, and P4 (or bonding agents). For example, the adhesives P1, P2, P3, and P4 may include at least one of an optical clear adhesive (OCA), a pressure-sensitive adhesive (PSA), a heat-responsive adhesive, a general adhesive, and double-sided tape.

According to an embodiment, the display panel 330 may include multiple pixels. The polarizer 320 may selectively allow light, which is generated from a light source of the display panel 330 and vibrates in a predetermined direction, to pass therethrough. The display panel 330 and the polarizer 320 may be integrally formed. The first display 300 may include a touch panel (not illustrated). Although not illustrated, the display panel 330 may further include a control circuit. The control circuit may include a display driver IC (DDI) and/or a touch display driver IC (TDDI) arranged in a chip-on-panel (COP) or chip-on-film (COF) type.

According to an embodiment, the polymer layer 340 may be disposed under the display panel 330 to provide a dark background for securing visibility of the display panel 330, and may be made of a buffering material for a buffering action.

According to an embodiment, the metal sheet layer 350 may provide a bending characteristic to the first display 300. For example, the metal sheet layer 350 may include a first planar portion 451 corresponding to the first surface (e.g., the first surface 111 in FIG. 2A) of the first housing (e.g., the first housing 110 in FIG. 2A), a second planar portion 452 corresponding to the third surface (e.g., the third surface 121 in FIG. 2A) of the second housing (e.g., the second housing 120 in FIG. 2A), and a bendable portion 453 corresponding to the hinge module (e.g., the hinge module 140 in FIG. 2A) and connecting the first planar portion 451 and the second planar portion 452.

According to an embodiment, the metal sheet layer 350 may be formed such that the digitizer 360 disposed thereunder has a structure for recognizing an external electronic pen through the metal sheet layer 350. The metal sheet layer 350 may have a pattern structure capable of passing a magnetic field to detect when a digitizer 360 disposed thereunder comes into contact with or approaches the outer surface of the first display 300 from the outside of the foldable electronic device (e.g., the foldable electronic device 100 in FIG. 2A). The metal sheet layer 350 may include at least one of steel use stainless (SUS) (e.g., stainless steel (STS)), Cu, Al, or metal CLAD (e.g., a laminated member in which SUS and Al are alternately disposed). In some embodiments, the metal sheet layer 350 may include other alloy materials. According to some embodiments, the metal sheet layer 350 may help reinforce the rigidity of the electronic device (e.g., the electronic device 100 in FIG. 1A), and may be used to shield ambient noise and dissipate heat emitted from surrounding heat-emitting components.

According to an embodiment, the digitizer 360 may be disposed beneath the metal sheet layer 350 and may include a detection member that receives an input from an electronic pen (e.g., a stylus). For example, the digitizer 360 is a detection member and may include a coil member arranged on a dielectric substrate to detect an electromagnetically induction-type resonance frequency applied from the electronic pen. For example, when an AC voltage is applied through the coil member of the digitizer 360, a magnetic field may be formed, inducing a current in the internal coil of a nearby electronic pen according to the principle of electromagnetic induction. This current forms a resonant frequency through the internal circuit of the pen which may be detected by the digitizer 360.

According to an embodiment, the first display 300 may include one or more functional members (not illustrated) disposed between the polymer layer 340 and the metal sheet layer 350, between the digitizer 360 and the metal sheet layer 350, and/or under the metal sheet layer 350. According to an embodiment, the functional members may include a graphite sheet for heat dissipation, an added display, a force touch FPCB, a fingerprint sensor FPCB, an antenna radiator for communication, a conductive/non-conductive tape, or an open cell sponge.

According to an embodiment, when the functional members are not bendable, the functional members may be separately disposed in the first housing (e.g., the first housing 110 in FIG. 2A) and the second housing (e.g., the second housing 120 in FIG. 2A). The functional members, if bendable, may be disposed from the first housing (e.g., the first housing 110 in FIG. 2A) to at least a portion of the second housing (e.g., the second housing 120 in FIG. 2A) across the hinge module (e.g., the hinge module 140 in FIG. 2A).

According to an embodiment, the electronic device (e.g., the electronic device 100 in FIG. 2A) may include a camera device (e.g., the first camera device 105 in FIG. 2A) disposed under the first display 300 and detecting an external environment through the first display 300. In some embodiments, the electronic device (e.g., the electronic device 100 in FIG. 2A) may also include at least one sensor module (e.g., the sensor module 104 in FIG. 2A) (e.g., an illuminance sensor, a proximity sensor, or a TOF sensor) disposed under the first display 300.

According to an embodiment, the polarizer 320, the display panel 330, the polymer layer 340, the digitizer 360, and the metal sheet layer 350 may include through holes 3201, 3301, 3401, 3501, and 3601 formed at corresponding positions for detecting an external environment through a camera device (e.g., the first camera device 105 in FIG. 2A) disposed thereunder.

In an embodiment, the display panel 330 and/or the polarizer 320 may make the through holes 3201 and 3301 unnecessary by controlling the transmittance of the corresponding area. The sizes of the through holes 3201, 3301, 3401, 3501, and 3601 may be formed based on the size of the camera device (e.g., the first camera device 105 in FIG. 2A) and/or the angle of view of the camera device (e.g., the first camera device 105 in FIG. 2A), and the sizes of respective through holes 3201, 3301, 3401, 3501, and 3601 may be different from each other.

According to an embodiment, the reinforcement plate 370 may be formed of a metal material and may include a first reinforcement plate 471 facing the first planar portion 451 of the metal sheet layer 350 and a second reinforcement plate 472 facing the second planar portion 452 of the metal sheet layer 350.

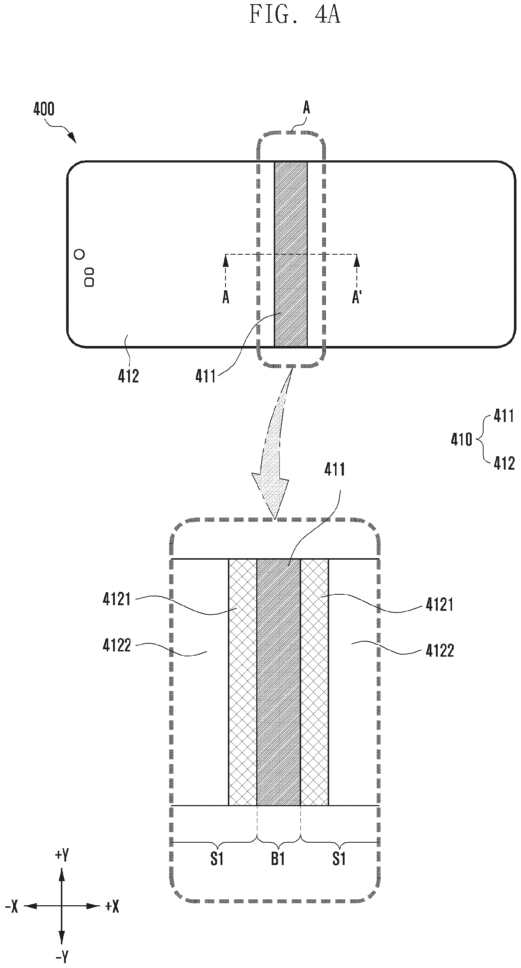

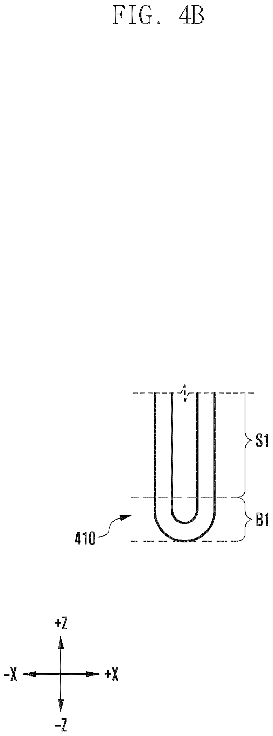

FIGS. 4A and 4B are views illustrating an electronic device 400 including a bending section B1 according to an embodiment of the disclosure.

FIG. 4A illustrates the state of the electronic device 400 according to an embodiment before being bent.

FIG. 4B illustrates the electronic device 400 according to an embodiment after being bent.

In describing the electronic device 400 according to an embodiment of the disclosure, the length direction of the electronic device 400 may refer to the X-axis direction, and the width direction of the electronic device 400 may refer to the Y-axis direction.

The electronic device 400 illustrated in FIGS. 4A and 4B may refer to the electronic device 101 illustrated in FIG. 2A, or may include at least a portion of the electronic device 101 illustrated in FIG. 2A.

Referring to FIGS. 4A and 4B, the electronic device 400 according to an embodiment of the disclosure may include a display unit 410. The display unit 410 may be disposed on one surface of a housing (e.g., the housings 210 and 220 in FIG. 2A). The display unit 410 may extend along the length direction (e.g., the X-axis direction) and the width direction (e.g., Y-axis direction) of the electronic device 400.

In an embodiment, the display unit 410 may include a bending portion 411 and/or straight extensions 412. The bending portion 411 may be an area in which the display unit 410 is bendable. At least a portion of the bending portion 411 may include a configuration (e.g., a grid pattern) that allows the display unit 410 to be easily bent.

In an embodiment, the straight extensions 412 may be respectively disposed at opposite ends of the bending portion 411. For example, the straight extensions 412 may extend along the length direction of the electronic device 400 (e.g., in the X-axis direction) from one end of the bending portion 411 (e.g., the end oriented in the -X-axis direction) and the other end located opposite the one end.

FIG. 4A illustrates an enlarged view of area A in which the bending portion 411 and the straight extensions 412 of the display unit 410 are in contact.

Referring to FIGS. 4A and 4B, the display unit 410 may include a bending section B1 and/or straight sections S1. The bending section B1 may refer to a section where the bending portion 411 of the display unit 410 is located and the display unit 410 is to be bent. The straight sections S1 may refer to sections where the display unit 410 is not bent and extends in a straight line. The straight sections S1 of the display unit 410 may be respectively located at the ends of the bending section B1.

Referring to FIG. 4B, the display unit 410 may be bent toward the Z-axis perpendicular to the X-axis direction in the bending section B1. The display unit 410 may extend in the straight sections S1 from the ends of the bending portion B1 in a direction parallel to the ends of the bending portion B1.

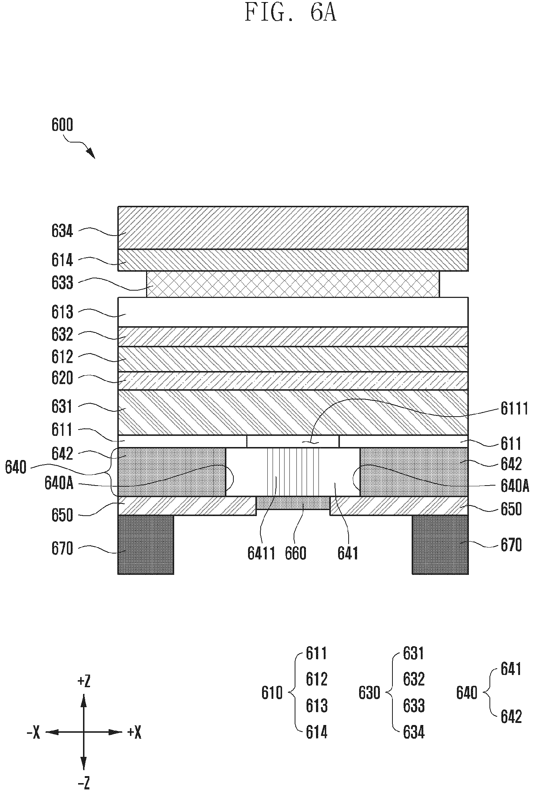

In an embodiment, the display unit 410 may include first metal areas 4121 and/or second metal areas 4122. The first metal areas 4121 may be areas where metal is disposed to support the display panel 620 (see FIG. 6A). The first metal areas 4121 may be areas that extend while including the bending portion 411. The second metal areas 4122 may be areas in which a heat-dissipation metal is disposed.

In an embodiment, a portion of each of the first metal areas 4121 may be located in the bending section B1 of the display unit 410, and the remaining portion of each of the first metal areas 4121 may be located in a corresponding one of the straight sections S1 of the display unit 410. For example, each first metal area 4121 may include at least a portion of a bendable configuration (e.g., a grid pattern), and the bendable configuration of the first metal area 4121 may be disposed in the bending section B1.

In an embodiment, each second metal area 4122 may be located in a corresponding one of the straight sections S1 of the display unit 410.

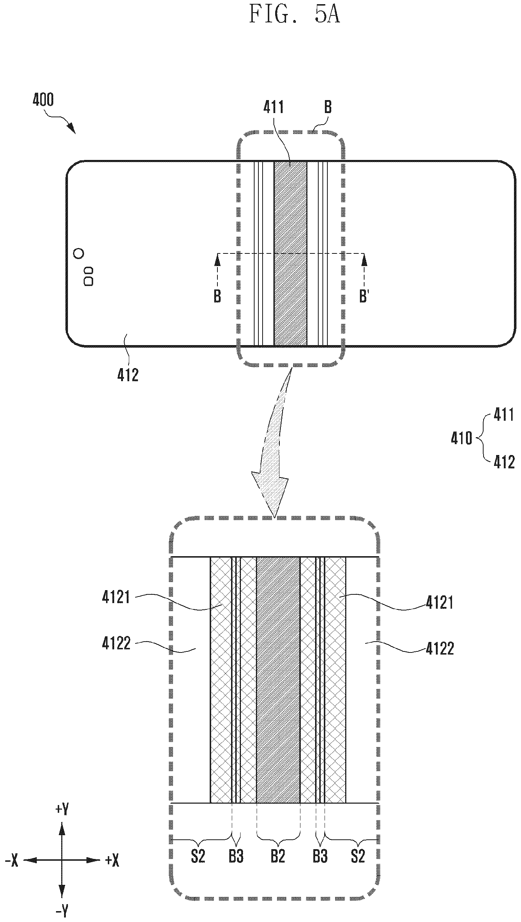

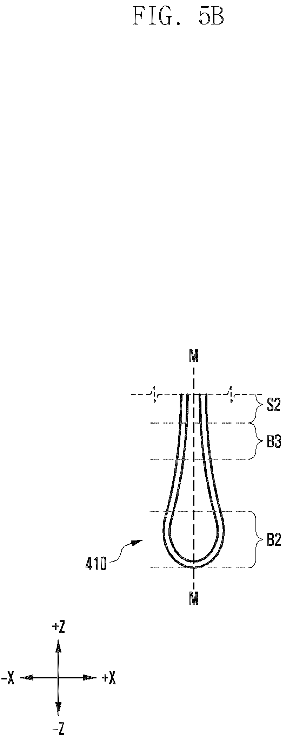

FIGS. 5A and 5B are views illustrating an electronic device 400 including a first bending section B2 and second bending sections B3 according to an embodiment of the disclosure.

FIG. 5A illustrates the electronic device 400 including the second bending sections B3 according to one embodiment before being bent.

FIG. 5B illustrates the electronic device 400 including the second bending sections B3 according to one embodiment after being bent.

The electronic device 400 illustrated in FIGS. 5A and 5B may refer to the electronic device 101 illustrated in FIG. 2A, or may include at least a portion of the electronic device 101 illustrated in FIG. 2A.

Referring to FIGS. 5A and 5B, the electronic device 400 according to an embodiment of the disclosure may include a display unit 410. The display unit 410 may be disposed on one surface of a housing (e.g., the housings 210 and 220 in FIG. 2A). The display unit 410 may extend along the length direction (e.g., the X-axis direction) and the width direction (e.g., Y-axis direction) of the electronic device 400.

In an embodiment, the display unit 410 may include a bending portion 411 and/or straight extensions 412.

In an embodiment, the straight extensions 412 may be respectively disposed at opposite ends of the bending portion 411. For example, the straight extensions 412 may extend along the length direction of the electronic device 400 (e.g., in the X-axis direction) from one end of the bending portion 411 (e.g., the end oriented in the -X-axis direction) and the other end located opposite the one end.

FIG. 5A illustrates an enlarged view of area B in which the bending portion 411 and the straight extensions 412 of the display unit 410 are in contact.

Referring to FIGS. 5A and 5B, the display unit 410 may include a first bending section B2, second bending sections B3, and/or straight sections S2. The first bending section B1 may refer to a section where the bending portion 411 is located and the display unit 410 is to be bent. The second bending sections B3 may refer to sections in each of which the display unit 410 is bent in the opposite direction of the first bending section B2. The second bending sections B3 may be spaced apart from the first bending section B2. The straight sections S2 may refer to sections in which the display unit 410 is not bent and extends in a straight line. The straight sections S2 of the display unit 410 may be positioned at the ends of the second bending sections B3.

Referring to FIG. 5B, the display unit 410 may be bent toward the Z-axis perpendicular to the X-axis direction in the first bending section B2. The display unit 410 may be at least partially bent in the direction toward the center line M-M of the display unit 410 in the first bending section B2.

Referring to FIG. 5B, the display unit 410 may be bent in the second bending sections B2 in the opposite direction to that in the first bending section B1. For example, the display unit 410 may be bent in the second bending sections B2 in the direction opposite to the direction toward the center line M-M.

Referring to FIG. 5B, the display unit 410 may extend in the straight sections S2 from the ends of the second bending portions B3 in a direction parallel to the ends of the bending portions B3.

In an embodiment, the display unit 410 may include first metal areas 4121 and/or second metal areas 4122. The first metal areas 4121 may be areas where metal is disposed to support the display panel 620 (see FIG. 6A). The first metal areas 4121 may be areas that extend while including the bending portion 411. The second metal areas 4122 may be areas in which a heat-dissipation metal is disposed.

In an embodiment, the first metal areas 4121 may be at least partially located in the first bending section B2, the second bending sections B3, and/or the straight sections S2. For example, the first metal area 4121 may include a configuration that allows bending in a direction toward the center line M-M of FIG. 5B or away from the center line M-M. A configuration that allows bending toward the center line M-M in the first metal areas 412 1 may be disposed in the first bending section B2. A configuration that allows bending in the first metal areas 4121 away from the center line M-M may be disposed in the second bending sections B3.

In an embodiment, each second metal area 4122 may be located in a corresponding one of the straight sections S2 of the display unit 410.

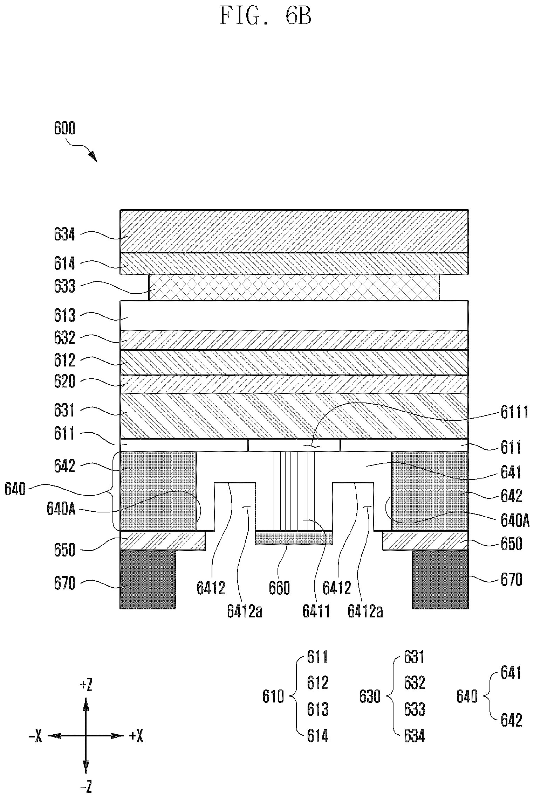

FIGS. 6A and 6B are views illustrating a display unit 600 according to an embodiment of the disclosure.

FIG. 6A is a view illustrating a metal layer 640 including a first bending area 6411 according to an embodiment of the disclosure.

FIG. 6B is a view illustrating a metal layer 640 including a first bending area 6411 and second bending areas 6412 according to an embodiment of the disclosure.

FIG. 6A may be a cross-sectional view of the display unit 410 of FIG. 4A taken along line A-A'.

FIG. 6B may be a cross-sectional view of the display unit 410 of FIG. 5A taken along line B-B'.

In explaining the display unit 600 according to an embodiment of the disclosure, the height direction of the display unit 600 may refer to the Z-axis direction, and the length direction of the display unit 600 may refer to the X-axis direction.

The display unit 600 illustrated in FIGS. 6A and 6B may refer to the first display 300 illustrated in FIG. 3, or may include at least a portion of the first display 300 illustrated in FIG. 3.

The display unit 600 according to an embodiment of the disclosure may include an adhesive layer 610, a display panel 620, a protective layer 630, a metal layer 640, a resin layer 650, a foreign matter prevention layer 660, and/or a waterproof layer 670. The adhesive layer 610, the display panel 620, the protective layer 630, the metal layer 640, the resin layer 650, the foreign matter prevention layer 660, and the waterproof layer 670 may extend in the length direction of the display unit 600 (e.g., the X-axis direction).

In an embodiment, respective layers (e.g., the display panel 620 and the metal layer 640 included in the display unit 600 may be laminated in the height direction of the display unit 600 (e.g., the Z-axis direction).

The display panel 620 illustrated in FIG. 6A may refer to the display panel 330 of FIG. 3 or may include at least a portion of the display panel 330 of FIG. 3.

In an embodiment, the protective layer 630 may include a first protective layer 631, a second protective layer 632, a third protective layer 633, and/or a fourth protective layer 634.

In an embodiment, the first protective layer 631 may be the polymer layer 340 illustrated in FIG. 3. The first protective layer 631 may serve to provide a dark background for ensuring the visibility of the display panel 620, and may include a buffering material. The second protective layer 632 may be a polarizer 320 as illustrated in FIG. 3. The second protective layer 632 may selectively transmit light generated from a light source of the display panel 620. The third protective layer 633 may be an ultrathin glass (UTG) including a tempered glass material for protecting the display panel 620. The fourth protective layer 634 may be a window layer 310 as illustrated in FIG. 3. The fourth protective layer 634 may serve as a protective layer for protecting the display panel 620 and may further include a coating layer on at least a portion thereof.

In an embodiment, the adhesive layer 610 may include a first adhesive layer 611, a second adhesive layer 612, a third adhesive layer 613, and/or a fourth adhesive layer 614. The adhesive layer 610 may include at least one of an optical clear adhesive (OCA), a pressure-sensitive adhesive (PSA), a heat-reactive adhesive, a general adhesive, or double-sided tape.

In an embodiment, the adhesive layer 610 may be positioned between respective layers (e.g., the display panel 620, the protective layer 630, the metal layer 640) included in the display unit 600 and may serve to bond and connect the respective layers. For example, the first adhesive layer 611 may be disposed between the metal layer 640 and the first protective layer 631. The second adhesive layer 612 may be disposed between the display panel 620 and the second protective layer 632. The third adhesive layer 613 may be disposed between the second protective layer 632 and the third protective layer 633. The fourth adhesive layer 614 may be disposed between the third protective layer 633 and the fourth protective layer 634.

In an embodiment, the metal layer 640 may include a first metal layer 641 and/or a second metal layer 642. The first metal layer 641 may serve to reinforce the display unit 600. For example, the first metal layer 641 may serve to reinforce the strength of the display unit 600 in a bending section(s) B1 or B2 and B3 (see FIGS. 4A and 5A) and the straight sections S1 or S2 (see FIGS. 4A and 5A) of the display unit 600.

In an embodiment, the second metal layer 642 may include a heat dissipation metal to improve the heat dissipation performance of the display unit 600.

In an embodiment, the first metal layer 641 may include a material having greater rigidity than the second metal layer 642. For example, the first metal layer 641 may include a stainless steel or titanium (Ti) material.

In an embodiment, the second metal layer 642 may include a material having greater heat dissipation performance than the first metal layer 641. For example, the second metal layer 642 may include a metal having heat dissipation performance, such as copper (Cu), aluminum (Al), or graphite.

Referring to FIG. 6A, the first metal layer 641 according to an embodiment may include a first bending area 6411. The first bending region 6411 may be formed in a grid pattern shape to allow the display unit 600 to be bent. For example, the first bending area 6411 may be formed in a grid pattern shape that at least partially includes empty spaces to allow the display unit 600 to be easily bent. The first bending area 6411 may be formed in the bending section B1 of the display unit 410 as illustrated in FIG. 4A. The first metal layer 641, which includes a material having greater rigidity than the second metal layer 642, may be advantageous to form a grid pattern.

Referring to FIG. 6A, the second metal layer 642 according to an embodiment may be disposed at opposite ends of the first metal layer 641. For example, the second metal layer 642 may be disposed at the ends of the first metal layer 641 in the -X-axis direction and the +X-axis direction.

Referring to FIG. 6A, the second metal layer 642 according to an embodiment may be disposed at a predetermined distance from the first bending area 6411 of the first metal layer 641. For example, a bonding surface 640a where the first metal layer 641 and the second metal layer 642 come into contact may be spaced apart from the first bending area 6411 of the first metal layer 641 in the -X-axis direction or the +X-axis direction.

Referring to FIG. 6B, the first metal layer 641 according to an embodiment may include the first bending area 6411 and/or the second bending areas 6412. The first bending area 6411 may be formed in a grid pattern shape to allow the display unit 600 to be bent. The first bending area 6411 may be formed in the first bending section B2 of the display unit 410 as illustrated in FIG. 5A.

Referring to FIG. 6B, the second bending areas 6412 may be spaced apart from the first bending area 6411. For example, the second bending areas 6412 may be spaced apart from the first bending area 6411 in the -X-axis direction and the +X-axis direction.

In an embodiment, the second bending areas 6412 may include bending grooves 6412a, respectively. The bending grooves 6412a may be formed by partially etching the second bending areas 6412. The bending grooves 6412a may serve to enable the display unit 600 to be easily bent in the second bending areas 6412. The second bending areas 6412 may be formed in the second bending section B3 of the display unit 410 as illustrated in FIG. 5A.

Referring to FIG. 6B, the second metal layer 642 according to an embodiment may be disposed at opposite ends of the first metal layer 641. For example, the second metal layer 642 may be disposed at the ends of the first metal layer 641 in the -X-axis direction and the +X-axis direction.

Referring to FIG. 6B, the second metal layer 642 according to an embodiment may be disposed at a predetermined distance from the second bending areas 6412 of the first metal layer 641. For example, bonding surfaces 640a where the first metal layer 641 and the second metal layer 642 come into contact may be spaced apart from the second bending areas 6412 of the first metal layer 641 in the - X-axis direction or the +X-axis direction.

In an embodiment, the first metal layer 641 may be bonded to the second metal layer 642 at the bonding surface 640a via an adhesive member. The adhesive member may include at least one of an optical clear adhesive (OCA), a pressure-sensitive adhesive (PSA), a heat-reactive adhesive, a general adhesive, or double-sided tape. Alternatively, the first metal layer 641 may be bonded to the second metal layer 642 by welding at the bonding surfaces 640a.

In an embodiment, the first adhesive layer 611 may include a bending space 6111 in at least a portion thereof. The bending space 6111 may be formed at a position overlapping a position where the first bending area 6411 of the first metal layer 641 is formed.

In an embodiment, the first adhesive layer 611 may be disposed at positions where at least a portion thereof overlaps the bonding surfaces 640a of the metal layer 640. For example, referring to FIGS. 6A and 6B, the first adhesive layer 611 may be formed such that at least a portion thereof is disposed at X-axis positions where the bonding surfaces 640a are disposed and further extends in the -X-axis direction and the +X-axis direction based on the X-axis positions of the bonding surfaces 640a.

In an embodiment, the first adhesive layer 611 may be disposed such that at least a portion thereof overlaps the bonding surfaces 640a of the metal layer 640, and may serve to prevent the bonding surfaces 640a of the metal layer 640 from being recognized from the outside of the display unit 600.

In an embodiment, the resin layer 650 may be disposed on one surface of the metal layer 640. For example, the resin layer 650 may be disposed on a surface of the metal layer 640 oriented in the +Z-axis direction.

In an embodiment, the resin layer 650 may include an adhesive material and may serve to prevent corrosion of the metal layer 640 due to water flowing in from the outside. The resin layer 650 may include a polyethylene terephthalate (PET) material.

In an embodiment, the resin layer 650 may be disposed at positions where at least a portion thereof overlaps the bonding surfaces 640a of the metal layer 640. For example, referring to FIGS. 6A and 6B, the resin layer 650 may be formed such that at least a portion thereof is disposed at X-axis positions where the bonding surfaces 640a are disposed and further extends in the -X-axis direction and the +X-axis direction based on the X-axis positions of the bonding surfaces 640a.

In an embodiment, the foreign matter prevention layer 660 may be disposed on one surface of the metal layer 640. For example, the foreign matter prevention layer 660 may be disposed on the surface of the first bending area 6411 of the first metal layer 641 oriented in the -Z-axis direction.

In an embodiment, the foreign matter prevention layer 660 may serve to prevent foreign matter from entering the metal layer 640. For example, referring to FIGS. 6A and 6B, the foreign matter prevention layer 660 may serve to prevent foreign matter from entering the first bending area 6411 of the first metal layer 641. The foreign matter prevention layer 660 may include a thermoplastic polyurethane (TPU) material.

In an embodiment, the waterproof layer 670 may be disposed on one surface of the resin layer 650. For example, the waterproof layer 670 may be disposed on a surface of the resin layer 650 oriented in the -Z-axis direction. The waterproof layer 670 may serve to prevent water from entering the display unit 600 or reduce the inflow of water. The waterproof layer 670 may include a waterproof material.

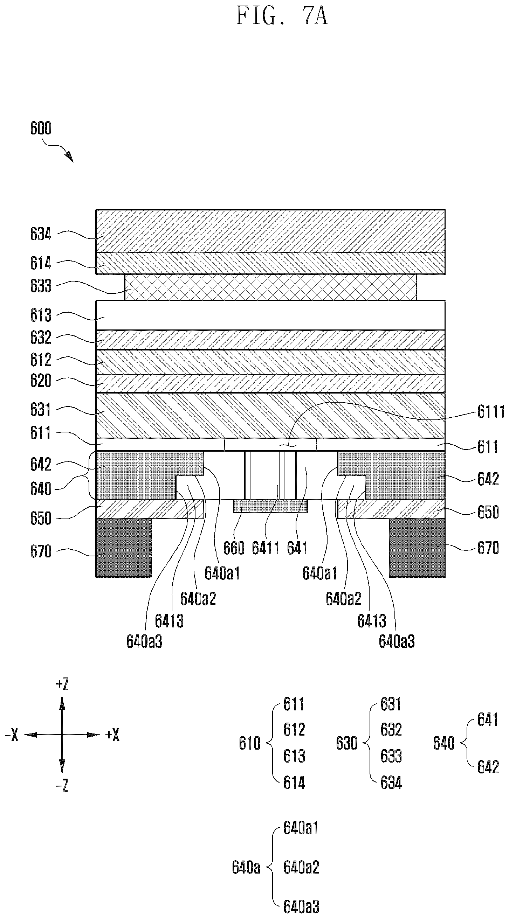

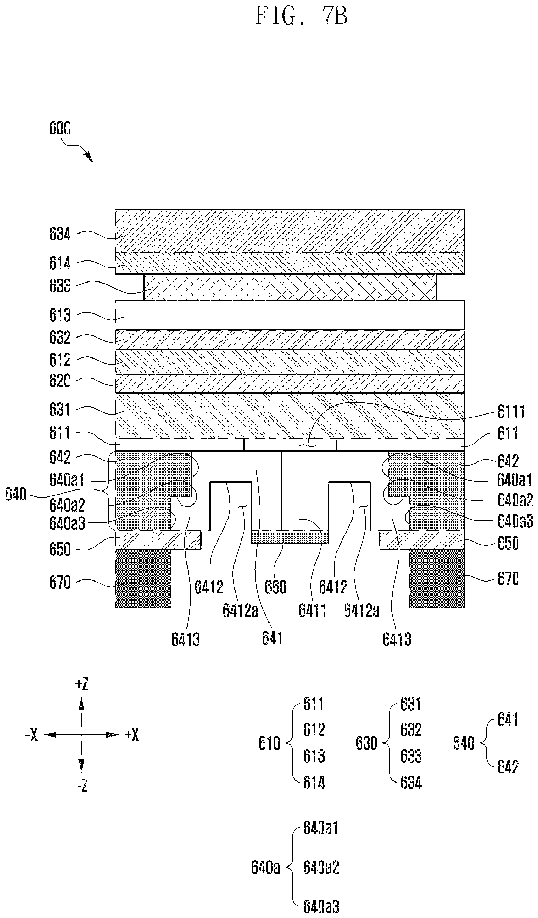

FIGS. 7A and 7B are views illustrating a display unit 600 including multiple bonding surfaces 640a according to an embodiment of the disclosure.

FIG. 7A is a view illustrating a metal layer 640 including multiple bonding surfaces 640a and a first bending area 6411 according to an embodiment of the disclosure.

FIG. 7B is a view illustrating a metal layer 640 including multiple bonding surfaces 640a, a first bending area 6411, and second bending areas 6412 according to an embodiment of the disclosure.

FIG. 7A may be a cross-sectional view of the display unit 410 of FIG. 4A taken along line A-A'.

FIG. 7B may be a cross-sectional view of the display unit 410 of FIG. 5A taken along line B-B'.

Referring to FIGS. 7A and 7B, the display unit 600 may include an adhesive layer 610, a display panel 620, a protective layer 630, a metal layer 640, a resin layer 650, a foreign matter prevention layer 660, and/or a waterproof layer 670. The functions and arrangements of the adhesive layer 610, the display panel 620, the protective layer 630, the resin layer 650, the foreign matter prevention layer 660, and/or the waterproof layer 670 illustrated in FIGS. 7A and 7B may be substantially the same as the functions and arrangements of respective layers illustrated in FIGS. 6A and 6B.

In an embodiment, the metal layer 640 may include a first metal layer 641 and/or a second metal layer 642. The first metal layer 641 may serve to reinforce the display unit 600. The second metal layer 642 may include a heat dissipation metal to improve the heat dissipation performance of the display unit 600.

The metal layer 640 illustrated in FIGS. 7A and 7B may have the same function and material as the metal layer 640 illustrated in FIGS. 6A and 6B.

Referring to FIGS. 7A and 7B, the second metal layer 642 may be disposed at opposite ends of the first metal layer 641. For example, the second metal layer 642 may be disposed at the ends of the first metal layer 641 in the -X-axis direction and the +X-axis direction.

Referring to FIGS. 7A and 7B, the first metal layer 641 may include extension areas 6413. For example, the first metal layer 641 may include extension areas 6413 in which opposite ends of the first metal layer 641 extend further in the - X-axis direction and the +X-axis direction than other areas. The first metal layer 641 may be in contact with the second metal layer 642 in the extension areas 6413.

Referring to FIG. 7A, the first metal layer 641 according to an embodiment may include a first bending area 6411. The first bending area 6411 may be formed in a grid pattern shape to allow the display unit 600 to be bent. The first bending area 6411 may be formed in the bending section B1 of the display unit 410 as illustrated in FIG. 4A.

Referring to FIG. 7B, the first metal layer 641 according to an embodiment may include the first bending area 6411 and/or the second bending areas 6412. The first bending area 6411 may be formed in a grid pattern shape to allow the display unit 600 to be bent. The first bending area 6411 may be formed in the first bending section B2 of the display unit 410 as illustrated in FIG. 5A. The second bending areas 6412 may be formed in the second bending sections B3 of the display unit 410 as illustrated in FIG. 5A.

Referring to FIG. 7B, the second bending areas 6412 may be spaced apart from the first bending area 6411. For example, the second bending areas 6412 may be positioned in the -X-axis direction and the +X-axis direction with respect to the first bending area 6411. The second bending areas 6412 may include bending grooves 6412a, respectively. The bending grooves 6412a may be formed by partially etching the second bending areas 6412. The bending grooves 6412a may serve to enable the display unit 600 to be easily bent in the second bending areas 6412.

Referring to FIGS. 7A and 7B, the metal layer 640 according to an embodiment may include multiple bonding surfaces 640a where the first metal layer 641 and the second metal layer 642 are in contact. First bonding surfaces 640a1 may be the surfaces of the display unit 600 formed parallel to the height direction (e.g., the Z-axis direction). Second bonding surfaces 640a2 may be surfaces connected to the first bonding surfaces 640a1 and extending in a direction perpendicular to the first bonding surfaces 640a1. Third bonding surfaces 640a3 may be surfaces connected to the second bonding surfaces 640a2 and extending in a direction perpendicular to the second bonding surfaces 640a2.

Referring to FIG. 7A, the first bonding surfaces 640a1, the second bonding surfaces 640a2, and the third bonding surfaces 640a3 according to an embodiment may be spaced apart from the first bending area 6411 of the first metal layer 641 in the -X-axis direction and the +X-axis direction.

Referring to FIG. 7B, the first bonding surfaces 640a1, the second bonding surfaces 640a2, and the third bonding surfaces 640a3 according to an embodiment may be spaced apart from the second bending areas 6412 of the first metal layer 641 in the -X-axis direction and the +X-axis direction.

In FIGS. 7A and 7B, each of the multiple bonding surfaces 640a is illustrated as extending substantially perpendicularly to a bonding surface 640a adjacent thereto, but this is exemplary, and the extension direction of each of the bonding surfaces 640a may not be limited thereto. For example, the second bonding surfaces 640a2 may extend in a direction inclined relative to the first bonding surfaces 640a1 rather than in a direction perpendicular to the first bonding surfaces 640a1.

In an embodiment, when the metal layer 640 includes multiple bonding surfaces 640a, the bonding between the first metal layer 641 and the second metal layer 642 may be more firmly formed compared to when the metal layer 640 includes a single bonding surface 640a.

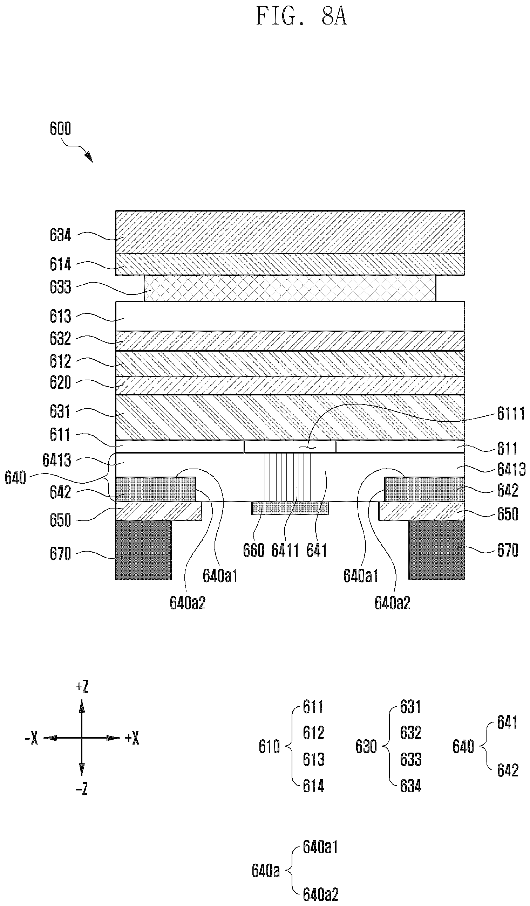

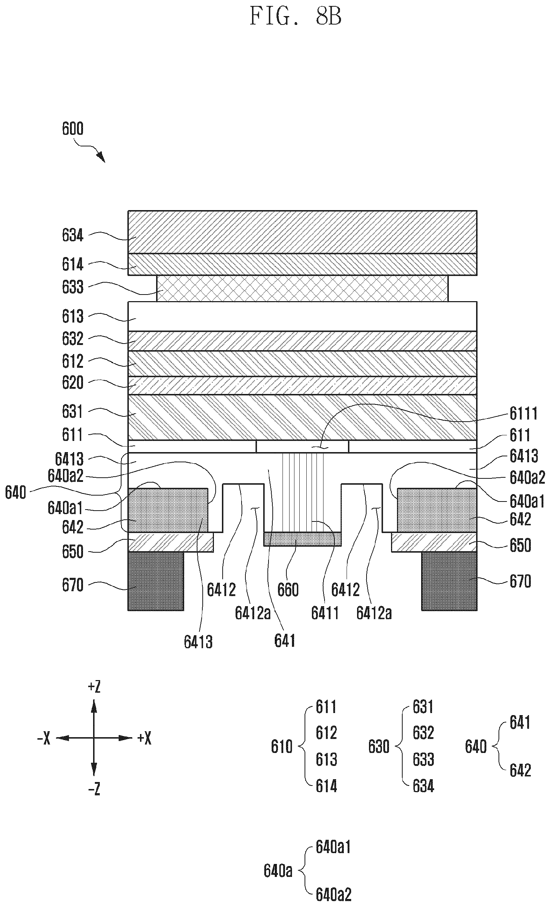

FIGS. 8A and 8B are views illustrating a display unit 600 including two bonding surfaces 640a according to an embodiment of the disclosure.

FIG. 8A is a view illustrating a metal layer 640 including two bonding surfaces 640a and a first bending area 6411 according to an embodiment of the disclosure.

FIG. 8B is a view illustrating a metal layer 640 including two bonding surfaces 640a, a first bending area 6411, and two second bending areas 6412 according to an embodiment of the disclosure.

FIG. 8A may be a cross-sectional view of the display unit 410 of FIG. 4A taken along line A-A'.

FIG. 8B may be a cross-sectional view of the display unit 410 of FIG. 5A taken along line B-B'.

Referring to FIGS. 8A and 8B, the display unit 600 may include an adhesive layer 610, a display panel 620, a protective layer 630, a metal layer 640, a resin layer 650, a foreign matter prevention layer 660, and/or a waterproof layer 670. The functions and arrangements of the adhesive layer 610, the display panel 620, the protective layer 630, the resin layer 650, the foreign matter prevention layer 660, and/or the waterproof layer 670 illustrated in FIGS. 8A and 8B may be substantially the same as the functions and arrangements of respective layers illustrated in FIGS. 6A and 6B.

The metal layer 640 illustrated in FIGS. 8A and 8B may have the same function and material as the metal layer 640 illustrated in FIGS. 6A and 6B.

Referring to FIGS. 8A and 8B, the second metal layer 642 may be disposed at opposite ends of the first metal layer 641. For example, the second metal layer 642 may be disposed at the ends of the first metal layer 641 in the -X-axis direction and the +X-axis direction.

Referring to FIGS. 8A and 8B, the first metal layer 641 may include extension areas 6413. For example, the first metal layer 641 may include extension areas 6413 in which opposite ends of the first metal layer 641 extend further in the - X-axis direction and the +X-axis direction than other areas. The first metal layer 641 may be in contact with the second metal layer 642 in the extension areas 6413.

Referring to FIGS. 8A and 8B, the extension areas 6413 of the first metal layer 641 may be disposed on one surface of the second metal layer 642. For example, the extension areas 6413 of the first metal layer 641 may be disposed on the surface of the second metal layer 642 oriented in the +Z-axis direction vertically.

Referring to FIG. 8A, the first metal layer 641 according to an embodiment may include a first bending area 6411. The first bending area 6411 may be formed in a grid pattern shape to allow the display unit 600 to be bent. The first bending area 6411 may be formed in the bending section B1 of the display unit 410 as illustrated in FIG. 4A.

Referring to FIG. 8B, the first metal layer 641 according to an embodiment may include the first bending area 6411 and/or the second bending areas 6412. The second bending areas 6412 may be spaced apart from the first bending area 6411. For example, the second bending areas 6412 may be positioned in the -X-axis direction and the +X-axis direction with respect to the first bending area 6411. The first bending area 6411 may be formed in the first bending section B2 of the display unit 410 as illustrated in FIG. 5A. The second bending areas 6412 may be formed in the second bending section B3 of the display unit 410 as illustrated in FIG. 5A.

Referring to FIGS. 8A and 8B, the metal layer 640 according to an embodiment may include two bonding surfaces 640a where the first metal layer 641 and the second metal layer 642 are in contact. First bonding surfaces 640a1 may be the surfaces of the display unit 600 formed parallel to the width direction (e.g., the X-axis direction). Second bonding surfaces 640a2 may be surfaces connected to the first bonding surfaces 640a1 and extending in a direction perpendicular to the first bonding surfaces 640a1. With respect to the first bonding surface 640a1, the first metal layer 641 may be positioned in the +Z-axis direction, and the second metal layer 642 may be positioned in the -Z-axis direction.

Referring to FIG. 8A, the first bonding surfaces 640a1 and the second bonding surfaces 640a2 according to an embodiment may be spaced apart from the first bending area 6411 of the first metal layer 641 in the -X-axis direction and the +X-axis direction.

Referring to FIG. 8B, the first bonding surfaces 640a1 and the second bonding surfaces 640a2 according to an embodiment may be spaced apart from the second bending areas 6412 of the first metal layer 641 in the -X-axis direction and the +X-axis direction.

In FIGS. 8A and 8B, the second bonding surfaces 640a2 are illustrated as extending substantially perpendicularly to the first bonding surfaces 640a1, but this is exemplary, and the extension direction of the second bonding surfaces 640a may not be limited thereto. For example, the second bonding surfaces 640a2 may extend in a direction inclined relative to the first bonding surfaces 640a1 rather than in a direction perpendicular to the first bonding surfaces 640a1.

In an embodiment, when a portion of the first metal layer 641 (e.g., the extension areas 6413) is disposed on one surface of the second metal layer 642, the bonding between the first metal layer 641 and the second metal layer 642 may be achieved more firmly compared to when the first metal layer 641 and the second metal layer 642 only in contact with each other on surfaces parallel to the height direction of the display unit 600 (e.g., the Z-axis direction).

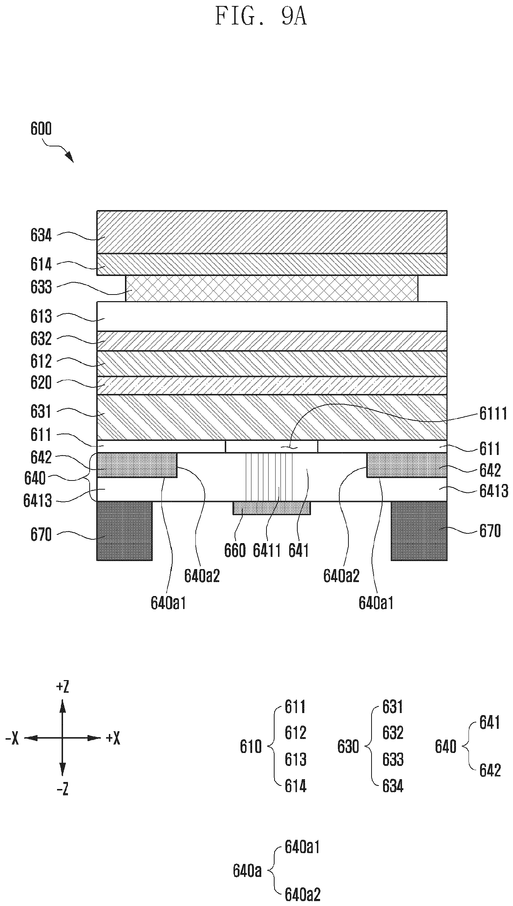

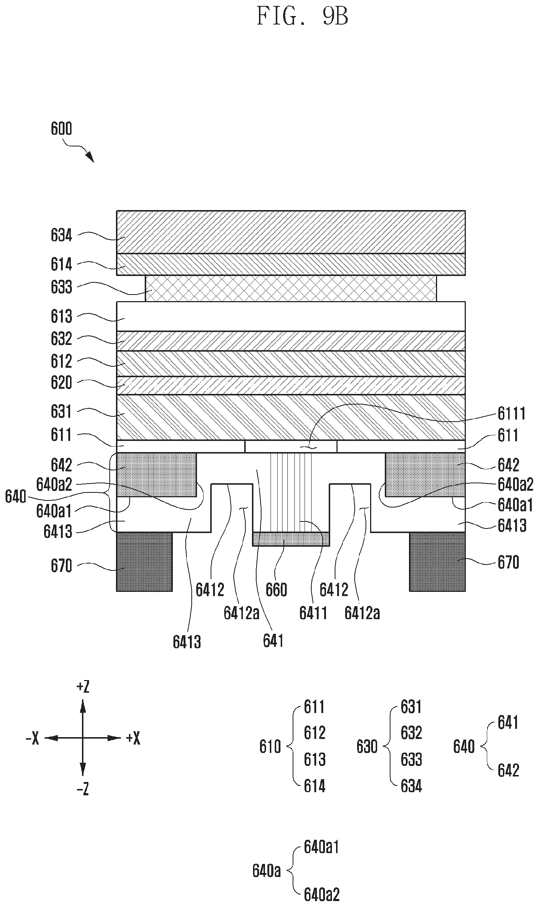

FIGS. 9A and 9B are views illustrating a display unit 600 including two bonding surfaces 640a according to an embodiment of the disclosure.

FIG. 9A is a view illustrating a metal layer 640 including a first bending area 6411 according to an embodiment of the disclosure.

FIG. 9B is a view illustrating a metal layer 640 including a first bending area 6411 and second bending areas 6412 according to an embodiment of the disclosure.

FIG. 9A may be a cross-sectional view of the display unit 410 of FIG. 4A taken along line A-A'.

FIG. 9B may be a cross-sectional view of the display unit 410 of FIG. 5A taken along line B-B'.

Referring to FIGS. 9A and 9B, the display unit 600 according to an embodiment may include an adhesive layer 610, a display panel 620, a protective layer 630, a metal layer 640, a foreign matter prevention layer 660, and/or a waterproof layer 670. The functions and arrangements of the adhesive layer 610, the display panel 620, the protective layer 630, the foreign matter prevention layer 660, and/or the waterproof layer 670 illustrated in FIGS. 9A and 9B may be substantially the same as the functions and arrangements of respective layers illustrated in FIGS. 6A and 6B.

The metal layer 640 illustrated in FIGS. 9A and 9B may have the same function and material as the metal layer 640 illustrated in FIGS. 6A and 6B.

Referring to FIGS. 9A and 9B, the second metal layer 642 may be disposed at opposite ends of the first metal layer 641. For example, the second metal layer 642 may be disposed at the ends of the first metal layer 641 in the -X-axis direction and the +X-axis direction.

Referring to FIGS. 9A and 9B, the first metal layer 641 may include extension areas 6413. For example, the first metal layer 641 may include extension areas 6413 in which opposite ends of the first metal layer 641 extend further in the - X-axis direction and the +X-axis direction than other areas. The first metal layer 641 may be in contact with the second metal layer 642 in the extension areas 6413.

Referring to FIGS. 9A and 9B, the second metal layer 642 may be disposed on one surfaces of the extension areas 6413 of the first metal layer 641. For example, the second metal layer 642 may be disposed on the surfaces of the extension areas 6413 of the first metal layer 641 oriented in the +Z-axis direction vertically.

Referring to FIG. 9A, the first metal layer 641 according to an embodiment may include a first bending area 6411. The first bending area 6411 may be formed in a grid pattern shape to allow the display unit 600 to be bent. The first bending area 6411 may be formed in the bending section B1 of the display unit 410 as illustrated in FIG. 4A.

Referring to FIG. 9B, the first metal layer 641 according to an embodiment may include the first bending area 6411 and/or the second bending areas 6412. The second bending areas 6412 may be spaced apart from the first bending area 6411. For example, the second bending areas 6412 may be positioned in the -X-axis direction and the +X-axis direction with respect to the first bending area 6411. The first bending area 6411 may be formed in the first bending section B2 of the display unit 410 as illustrated in FIG. 5A. The second bending areas 6412 may be formed in the second bending section B3 of the display unit 410 as illustrated in FIG. 5A.

Referring to FIGS. 9A and 9B, the metal layer 640 according to an embodiment may include two bonding surfaces 640a where the first metal layer 641 and the second metal layer 642 are in contact. First bonding surfaces 640a1 may be the surfaces of the display unit 600 formed parallel to the width direction (e.g., the X-axis direction). Second bonding surfaces 640a2 may be surfaces connected to the first bonding surfaces 640a1 and extending in a direction perpendicular to the first bonding surfaces 640a1. With respect to the first bonding surface 640a1, the second metal layer 642 may be positioned in the +Z-axis direction, and the first metal layer 641 may be positioned in the -Z-axis direction.

Referring to FIG. 9A, the first bonding surfaces 640a1 and the second bonding surfaces 640a2 according to an embodiment may be spaced apart from the first bending area 6411 of the first metal layer 641 in the -X-axis direction and the +X-axis direction.

Referring to FIG. 9B, the first bonding surfaces 640a1 and the second bonding surfaces 640a2 according to an embodiment may be spaced apart from the second bending areas 6412 of the first metal layer 641 in the -X-axis direction and the +X-axis direction.

In FIGS. 9A and 9B, the second bonding surfaces 640a2 are illustrated as extending substantially perpendicularly to the first bonding surfaces 640a1, but this is exemplary, and the extension direction of the second bonding surfaces 640a may not be limited thereto. For example, the second bonding surfaces 640a2 may extend in a direction inclined relative to the first bonding surfaces 640a1 rather than in a direction perpendicular to the first bonding surfaces 640a1.

In an embodiment, when the second metal layer 642 is disposed on a portion of the first metal layer 641 (e.g., the extension areas 6413), the bonding between the first metal layer 641 and the second metal layer 642 may be achieved more firmly compared to when the first metal layer 641 and the second metal layer 642 only in contact with each other on surfaces parallel to the height direction of the display unit 600 (e.g., the Z-axis direction).

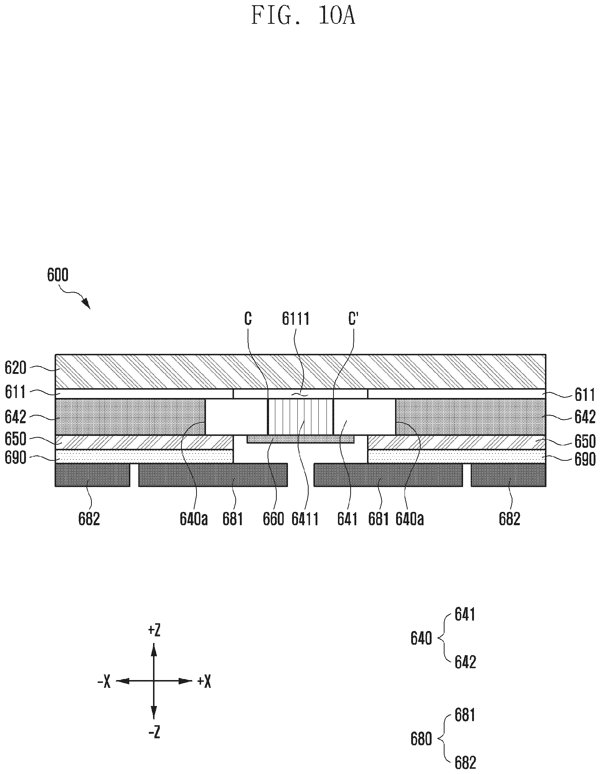

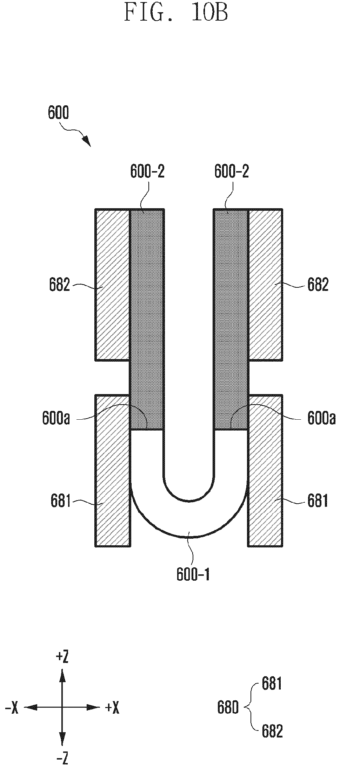

FIGS. 10A and 10B are views illustrating a display unit 600 including a support part 680 according to an embodiment of the disclosure.

FIG. 10A is a view illustrating the display unit 600 including the support part 680 according to an embodiment before being bent.

FIG. 10A may be a cross-sectional view of the display unit 410 of FIG. 4A taken along line A-A'.

FIG. 10B is a view illustrating the display unit 600 including the support part 680 according to an embodiment after being bent.

Referring to FIG. 10A, the display unit 600 according to an embodiment of the disclosure may include a first adhesive layer 611, a display panel 620, a metal layer 640, a resin layer 650, a foreign matter prevention layer 660, a support part 680, and/or an adhesive member 690.

The display panel 620, the metal layer 640, the resin layer 650, and foreign matter prevention layer 660 illustrated in FIG. 10A may respectively refer to the display panel 620, the metal layer 640, the resin layer 650, and the foreign matter prevention layer 660 illustrated in FIG. 6A.

The first adhesive layer 611 illustrated in FIG. 10A may refer to the first adhesive layer 611 illustrated in FIG. 6A, or may include at least a portion of the first adhesive layer 611 in FIG. 6A. For example, the first adhesive layer 611 of FIG. 10 may include at least one of an optical clear adhesive (OCA), a pressure-sensitive adhesive (PSA), a heat-reactive adhesive, a general adhesive, or double-sided tape.

Referring to FIG. 10A, the metal layer 640 according to an embodiment may be bonded to the display panel 620 via the first adhesive layer 611. For example, the display panel 620 may be disposed on one surface of the first adhesive layer 611, and the metal layer 640 may be disposed on the other surface of the first adhesive layer 611.

In an embodiment, the metal layer 640 may include a first metal layer 641 and/or a second metal layer 642.

According to an embodiment, the first metal layer 641 may include a first bending area 6411. The first bending area 6411 may be formed in a grid pattern shape to allow the display unit 600 to be bent.

Referring to FIG. 10A, the first bending area 6411 of the first metal layer 641 may be positioned in a section C-C' (e.g., the section between the straight line C and the straight line C' illustrated in FIG. 10A). The first bending area 6411 formed in a grid pattern may be positioned in the section C-C' and enable the display unit 600 to be easily bent.

The second metal layer 642 according to an embodiment may be disposed at opposite ends of the first metal layer 641. For example, the second metal layer 642 may be disposed at the ends of the first metal layer 641 in the -X-axis direction and the +X-axis direction.

In an embodiment, the adhesive member 690 may be disposed between the resin layer 650 and the support member 680, and may serve to bond the resin layer 650 and the support member 680. The adhesive member 690 may be a general adhesive or double-sided tape.

In an embodiment, the support part 680 may be disposed in an opposite direction to the direction in which the display panel 620 is positioned with respect to the metal layer 640. For example, referring to FIG. 10A, with respect to the display unit 600, the display panel 620 may be disposed at the end in the +Z-axis direction, and the support part 680 may be disposed at the end in the -Z-axis direction.

In an embodiment, the support part 680 may include bending plates 681 and/or extension plates 682. The bending plates 681 may be disposed at positions where at least a portion thereof overlaps the first bending area 6411 of the first metal layer 641. For example, the bending plates 681 may be disposed at positions where at least a portion thereof overlaps the section C-C' where the first bending area 6411 is positioned.

Referring to FIG. 10B, the display unit 600 may include a first area 600-1 and/or second areas 600-2. The first area 600-1 may refer to an area including the first metal layer 641, and the second areas 600-2 may refer to areas including the second metal layer 642.

The bonding surfaces 600a between the areas illustrated in FIG. 10B may indicate positions where the bonding surfaces 640a between the metal layers 640 illustrated in FIG. 10A are disposed.

Referring to FIGS. 10A and 10B, in the display unit 600 according to an embodiment, the bonding surfaces 600a may be formed at portions where the display unit 600 extends in a straight line and are spaced apart from the first bending area 6411.

Referring to FIG. 10B, the bending plates 681 according to an embodiment may be disposed at positions where at least a portion thereof at least partially overlaps the bonding surfaces 600a. For example, the bending plates 681 may be formed at positions where the bonding surfaces 600a overlap, and may be formed to extend in a direction parallel to one direction (e.g., the +Z-axis direction) and a direction parallel to the other direction (e.g., the -Z-axis direction) with respect to the bonding surfaces 600a.

In an embodiment, the bending plates 681 may be disposed at positions overlapping the bonding surfaces 600a to support the first metal layer 641 and the second metal layer 642 so that the first and second metal layers do not separate from each other at the bonding surfaces 600a even when the display unit 600 is bent.

In an embodiment, the extension plates 682 may be disposed at positions overlapping at least a portion of the second areas 600-2. Referring to FIGS. 10A and 10B, the extension plates 682 may be disposed at positions overlapping a portion of the second areas 600-2 and may extend in a direction parallel to the direction in which the second areas 600-2 extend.

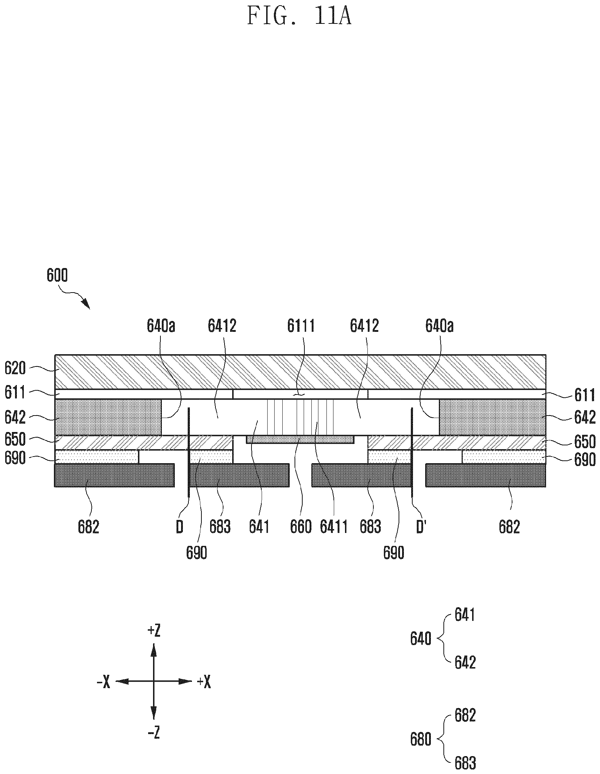

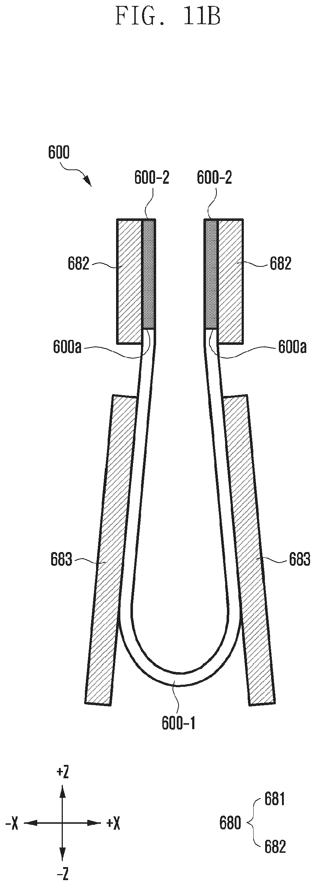

FIGS. 11A and 11B are views illustrating a display unit 600 including support plates 683 according to an embodiment of the disclosure.

FIG. 11A is a view illustrating the display unit 600 including the support plates 683 according to an embodiment before being bent.

FIG. 11A may be a cross-sectional view of the display unit 410 of FIG. 5A taken along line B-B'.

FIG. 11B is a view illustrating the display unit 600 including the support plates 683 according to an embodiment after being bent.

Referring to FIG. 11A, the display unit 600 according to an embodiment of the disclosure may include a first adhesive layer 611, a display panel 620, a metal layer 640, a resin layer 650, a foreign matter prevention layer 660, a support part 680, and/or an adhesive member 690.

The display panel 620, the metal layer 640, the resin layer 650, and foreign matter prevention layer 660 illustrated in FIG. 11A may respectively refer to the display panel 620, the metal layer 640, the resin layer 650, and the foreign matter prevention layer 660 illustrated in FIG. 6B.

The first adhesive layer 611 illustrated in FIG. 11A may refer to the first adhesive layer 611 illustrated in FIG. 6B, or may include at least a portion of the first adhesive layer 611 in FIG. 6B. For example, the first adhesive layer 611 of FIG. 11A may include at least one of an optical clear adhesive (OCA), a pressure-sensitive adhesive (PSA), a heat-reactive adhesive, a general adhesive, or double-sided tape.

Referring to FIG. 11A, the metal layer 640 according to an embodiment may be bonded to the display panel 620 via the first adhesive layer 611. For example, the display panel 620 may be disposed on one surface of the first adhesive layer 611, and the metal layer 640 may be disposed on the other surface of the first adhesive layer 611.

In an embodiment, the metal layer 640 may include a first metal layer 641 and/or a second metal layer 642.

The first metal layer 641 according to an embodiment may include the first bending area 6411 and/or the second bending areas 6412. The first bending area 6411 may be formed in a grid pattern shape to allow the display unit 600 to be bent. The second bending areas 6412 may be spaced apart from the first bending area 6411 in the -X-axis direction or the +X-axis direction. The second bending areas 6412 may be areas where the display unit 600 is bent in the direction opposite to that in the first bending area 6411.

Referring to FIG. 11A, the first bending area 6411 and the second bending areas 6412 of the first metal layer 641 may be positioned in a section D-D' (e.g., the section between the straight line D and the straight line D' illustrated in FIG. 11A).

The second metal layer 642 according to an embodiment may be disposed at opposite ends of the first metal layer 641. For example, the second metal layer 642 may be disposed at the ends of the first metal layer 641 in the -X-axis direction and the +X-axis direction.

In an embodiment, the adhesive member 690 may be disposed between the resin layer 650 and the support member 680, and may serve to bond the resin layer 650 and the support member 680. The adhesive member 690 may be a general adhesive or double-sided tape.

In an embodiment, the support part 680 may be disposed in an opposite direction to the direction in which the display panel 620 is positioned with respect to the metal layer 640. For example, referring to FIG. 11A, with respect to the display unit 600, the display panel 620 may be disposed at the end in the +Z-axis direction, and the support part 680 may be disposed at the end in the -Z-axis direction.

In an embodiment, the support part 680 may include support plates 683 and/or extension plates 682.

Referring to FIG. 11B, the display unit 600 may include a first area 600-1 and/or second areas 600-2. The first area 600-1 may refer to an area including the first metal layer 641, and the second areas 600-2 may refer to areas including the second metal layer 642.

The bonding surfaces 600a between the areas illustrated in FIG. 11B may indicate positions where the bonding surfaces 640a between the metal layers 640 illustrated in FIG. 11A are disposed.

Referring to FIG. 11B, in the display unit 600 according to an embodiment, the bonding surfaces 600a may be formed at portions where the display unit 600 extends in a straight line and are spaced apart from the positions where the support plates 683 are disposed.

Referring to FIG. 11B, the extension plates 682 according to an embodiment may be disposed at positions where at least a portion thereof overlaps the bonding surfaces 600a. For example, the extension plates 682 may be formed at positions where the bonding surfaces 600a overlap, and may be formed to extend in a direction parallel to one direction (e.g., the +Z-axis direction) and a direction parallel to the other direction (e.g., the -Z-axis direction) with respect to the bonding surfaces 600a.

In an embodiment, the extension plates 682 may be disposed at positions where the extension plates 682 overlap the bonding surfaces 600a to support the first metal layer 641 and the second metal layer 642 so that the first and second metal layers do not separate from each other at the bonding surfaces 600a even when the display unit 600 is bent.

In an embodiment, the support plates 683 may be disposed at positions where at least a portion thereof overlaps the first bending area 6411 and the second bending areas 6412 of the first metal layer 641. For example, referring to FIG. 11A, the support plates 681 may be at least partially disposed in a section D-D' section where the first bending area 6411 and the second bending areas 6412 are positioned.

An electronic device 101 according to an embodiment of the disclosure may include a housing 210 or 220, and a display unit 600 disposed on one surface of the housing 210 or 220.

The display unit 600 according to an embodiment of the disclosure may include a display panel 620, a protective layer 630 configured to protect the display panel 620, a metal layer 640 configured to support the display panel 620, and multiple adhesive layers 610, and may be at least partially bendable in a bending section B2 or B3.

In an embodiment, the metal layer 640 may include a first metal layer 641 including a first bending area 6411 disposed in the bending section B2 or B3 of the display unit 640, and second bending areas 6412 positioned at opposite ends of the first bending area 6412, the first metal layer 641 being configured to reinforce the strength of the display unit 600.

In an embodiment, the metal layer 640 may include a second metal layer 642 disposed at opposite ends of the first metal layer 641, and the opposite ends of the first metal layer 641 where the second metal layer 642 is disposed are spaced apart from the second bending areas 6412.

In an embodiment, the first bending area 6411 may be formed in a grid pattern shape.

In an embodiment, among the multiple adhesive layers 610, an adhesive layer 611 disposed on one surface of the metal layer 640 may be disposed at a position where at least a portion thereof overlaps surfaces where the first metal layer 641 and the second metal layer 642 are bonded.

In an embodiment, the first metal layer 641 may include a material having greater rigidity than the second metal layer 642.

In an embodiment, the second metal layer 642 may include a material having greater heat dissipation performance than the first metal layer 641.

In an embodiment, the metal layer 640 may include bonding surfaces 640a where the first metal layer 641 and the second metal layer 642 are in contact.

In an embodiment, the bonding surfaces 640a may include first bonding surfaces 640a1 where the first metal layer 641 is in contact with the second metal layer 642 at each of opposite ends thereof, second bonding surfaces 640a2 extending perpendicularly to the first bonding surfaces 640a1, and/or third bonding surfaces 640a3 positioned perpendicularly to the second bonding surfaces 640a2 and spaced apart from the first bonding surfaces 640a1.

In an embodiment, the first metal layer 641 may include an extension area 6413 extending from a portion of each of the opposite ends thereof.

In an embodiment, the second metal layer 642 may be disposed on one surface of the extension area 6413 of the first metal layer 641.

In an embodiment, the extension area 6413 may be disposed on one surface of the second metal layer 642.

In an embodiment, the second bending areas 6412 may each include a bending groove 6412a formed by etching at least a portion of the first metal layer 641.

In an embodiment, the display unit 600 may further include an extension plate 682 arranged on a side of the metal layer 640 opposite to the display panel 620.

In an embodiment, the extension plate 682 may be disposed at a position where at least a portion thereof overlaps the surfaces where the first metal layer 641 and the second metal layer 642 are bonded.

The display unit 600 according to an embodiment of the disclosure may include a display panel 620, a protective layer 630 configured to protect the display panel 620, a metal layer 640 configured to support the display panel 620, and multiple adhesive layers 610, and the display unit 600 is configured to be at least partially bendable in the bending section B1.

In an embodiment, the metal layer 640 may include a bending area 6411 disposed in the bending section B1 of the display unit 600, and a first metal layer 641 configured to reinforce the strength of the display unit 600.

In an embodiment, the metal layer 640 may include a second metal layer 642 disposed at opposite ends of the first metal layer 641, and the opposite ends of the first metal layer 641 where the second metal layer 642 is disposed may be spaced apart from the bending area 6411.

In an embodiment, the bending area 6411 may be formed in a grid pattern shape.

In an embodiment, the display unit 600 may further include a bending plate 681 disposed on a side of the metal layer 640 opposite to the display panel 620.

In an embodiment, the bending plate 681 may be disposed at a position where at least a portion thereof overlaps the bending area 6411 of the first metal layer 641 and the surfaces where the first metal layer 641 and the second metal layer 642 are bonded.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a housing (210, 220); and
a display unit (600) disposed on one surface of the housing,
wherein the display unit comprises:
a display panel (620);
a protective layer (630) configured to protect the display panel;
a metal layer (640) configured to support the display panel; and
multiple adhesive layers (610),
wherein at least a portion of the display unit is configured to be bendable in a bending section (B2, B3),
wherein the metal layer comprises:
a first metal layer (641) comprising: a first bending area (6411) disposed in the bending section of the display unit, and second bending areas (6412) positioned at opposite ends of the first bending area, the first metal layer being configured to reinforce strength of the display unit; and
a second metal layer (642) disposed at opposite ends of the first metal layer, and
wherein the opposite ends of the first metal layer where the second metal layer is disposed are spaced apart from the second bending areas.

2. The electronic device of claim 1, wherein the first bending area is formed in a grid pattern shape.

3. The electronic device of one of claims 1 and 2, wherein, among the multiple adhesive layers, an adhesive layer (611) disposed on one surface of the metal layer is disposed at a position where at least a portion thereof overlaps surfaces where the first metal layer and the second metal layer are bonded.

4. The electronic device of one of claims 1 to 3, wherein the first metal layer comprises a material with greater rigidity than the second metal layer.

5. The electronic device of one of claims 1 to 4, wherein the second metal layer comprises a material with greater heat dissipation performance than the first metal layer.

6. The electronic device of one of claims 1 to 5, wherein the metal layer comprises bonding surfaces 640a where the first metal layer and the second metal layer are in contact, and
wherein the bonding surfaces comprise:
a first bonding surface (640a1) where the first metal layer is in contact with the second metal layer at each of the opposite ends thereof;
a second bonding surface (640a2) extending perpendicularly to the first bonding surface; and
a third bonding surface (640a3) positioned perpendicularly to the second bonding surface and spaced apart from the first bonding surface.

7. The electronic device of one of claims 1 to 6, wherein the metal layer comprises bonding surfaces (640a) where the first metal layer and the second metal layer are in contact, and
wherein the bonding surfaces comprise:
a first bonding surface (640a1) where the first metal layer is in contact with the second metal layer at each of the opposite ends thereof; and
a second bonding surface (640a2) extending perpendicularly to the first bonding surface.

8. The electronic device of one of claims 1 to 7, wherein the first metal layer comprises an extension area (6413) extending from a portion of each of the opposite ends thereof, and
wherein the second metal layer is disposed on one surface of the extension area of the first metal layer.

9. The electronic device of one of claims 1 to 8, wherein the first metal layer comprises an extension area (6413) extending from a portion of each of the opposite ends thereof, and
wherein the extension area is disposed on one surface of the second metal layer.

10. The electronic device of one of claims 1 to 9, wherein the second bending areas of the first metal layer each comprise a bending groove (6412a) formed by etching at least a portion of the first metal layer.

11. The electronic device of one of claims 1 to 10, wherein the display unit further comprises an extension plate (682) disposed on a side of the metal layer opposite to the display panel, and
wherein the extension plate is disposed at a position where at least a portion thereof overlaps surfaces where the first metal layer and the second metal layer are bonded.

12. An electronic device comprising:
a housing (210, 220); and
a display unit (600) disposed on one surface of the housing,
wherein the display unit comprises:
a display panel (620);
a protective layer (630) configured to protect the display panel;
a metal layer (640) configured to support the display panel; and
multiple adhesive layers (610),
wherein at least a portion of the display panel is configured to be bendable in a bending section (B1),
wherein the metal layer comprises:
a first metal layer (641) comprising a bending area (6411) disposed in the bending section of the display unit, the first metal layer being configured to reinforce strength of the display unit, and
a second metal layer (642) disposed at opposite ends of the first metal layer, and
wherein the opposite ends of the first metal layer where the second metal layer is disposed are spaced apart from the bending area.

13. The electronic device of claim 12, wherein the bending area is formed in a grid pattern shape.

14. The electronic device of one of claims 12 to 13, wherein, among the multiple adhesive layers, an adhesive layer (611) disposed on one surface of the metal layer is disposed at a position where at least a portion thereof overlaps surfaces where the first metal layer and the second metal layer are bonded.

15. The electronic device of one of claims 12 to 14, wherein the display unit further comprises a bending plate (681) disposed on a side of the metal layer opposite to the display panel, and
wherein the bending plate is disposed at a position where at least a portion thereof overlaps the bending area of the first metal layer and surfaces where the first metal layer and the second metal layer are bonded.
